# EUROPEAN PATENT APPLICATION

(11) **EP 2 533 298 A1**
(43) Date of publication of application: **12.12.2012**
(21) Application number: 11830820.4
(22) Date of filing: 27.04.2011
(51) Int. Cl.: H01L 31/042

(54) **PHOTOVOLTAIC DEVICE AND METHOD FOR MANUFACTURING SAME**

(30) Priority: 05.10.2010 KR 20100097055
(71) Applicant: LG Innotek Co., Ltd., Seoul 100-714 (KR)
(72) Inventor: PAK, Hisun, Seoul 100-714 (KR)
(74) Representative: Novagraaf Technologies
(86) International application number: PCT/KR2011/003117
(87) International publication number: WO 2012/046934

(57) **Abstract**

Disclosed are a solar cell apparatus and a method of fabricating the same. The solar cell apparatus includes a substrate, a back electrode layer on the substrate, a light absorbing layer on the back electrode layer, a window layer on the light absorbing layer, and a conductive layer interposed between the back electrode layer and the light absorbing layer and including a first conductive oxide.

## Description

### Technical Field

The embodiment relates to a solar cell apparatus and a method of fabricating the same.

### Background Art

Recently, as energy consumption is increased, a solar cell apparatus has been developed to convert solar energy into electrical energy.

In particular, a CIGS-based solar cell apparatus, which is a PN hetero junction apparatus having a substrate structure including a glass substrate, a metallic back electrode layer, a P type CIGS-based light absorbing layer, a high resistance buffer layer, and an N type window layer, has been extensively used.

Various studies and research have been performed to improve electric characteristics of the solar cell apparatus, such as low resistance and high transmittance.

### Disclosure

### Technical Problem

The embodiment provides a solar cell apparatus having improved mechanical and electrical characteristics and a method of fabricating the same.

### Technical Solution

According to the embodiment, there is provided a solar cell apparatus including a substrate, a back electrode layer on the substrate, a light absorbing layer on the back electrode layer, a window layer on the light absorbing layer, and a conductive layer interposed between the back electrode layer and the light absorbing layer and including a first conductive oxide.

According to the embodiment, there is provided a solar cell apparatus including a back electrode layer, a first conductive oxide layer on the back electrode layer, a first conductive light absorbing layer on the first conductive oxide layer, and a second conductive window layer on the first conductive light absorbing layer.

According to the embodiment, there is provided a method of fabricating a solar cell apparatus. The method includes forming a back electrode layer on a substrate, forming a conductive layer by depositing a first conductive oxide on the back electrode layer, forming a light absorbing layer on the conductive layer, and forming a window layer on the light absorbing layer.

### Advantageous Effects

According to the solar cell apparatus of the embodiment, the conductive layer is interposed between the back electrode layer and the light absorbing layer. In this case, when the conductive layer includes a conductive oxide, the conductive layer can represent high boding strength between the back electrode layer and the light absorbing layer.

Therefore, since the conductive layer enhances the bonding strength between the back electrode layer and the light absorbing layer, the solar cell apparatus according to the embodiment can represent improved mechanical characteristics.

In addition, the window layer can be connected to the back electrode layer by the connection part. In this case, the connection part is connected to the back electrode layer through the conductive layer. In addition, since the conductive layer can be directly formed after the back electrode layer has been formed, a material, which is formed through a side reaction to degrade the connection characteristic, is not interposed between the back electrode layer and the conductive layer. Therefore, the connection characteristic between the conductive layer and the back electrode layer can be improved. In addition, both of the conductive layer and the connection part can include a conductive oxide, so that the connection characteristic between the connection part and the conductive layer can be improved. As a result, the connection characteristic between the connection part and the back electrode layer can be improved due to the conductive layer.

In addition, the conductive layer may include a P type conductive oxide such as a CIGS based compound constituting the light absorbing layer. Therefore, the conductive layer can improve the connection characteristic between the light absorbing layer and the back electrode layer.

Therefore, the solar cell apparatus according to the embodiment can represent an improved electrical characteristic.

In addition, the conductive layer covers the back electrode layer. Accordingly, the back electrode layer can be protected by the conductive layer. Therefore, in the solar cell apparatus according to the embodiment, the back electrode layer can be prevented from being corroded, and improved durability can be represented.

In addition, the conductive layer can include Na. The Na constituting the conductive layer is spread into the light absorbing layer in the process of forming the light absorbing layer to improve the characteristic of the light absorbing layer.

Therefore, the solar cell apparatus according to the embodiment can represent improved mechanical and electrical characteristics.

### Description of Drawings

FIG. 1 is a plan view showing a solar cell apparatus according to the embodiment;

FIG. 2 is a sectional view taken along line A-A' of FIG. 1; and

FIGS. 3 to 7 are sectional views showing the fabricating process of the solar cell apparatus according to the embodiment.

### Best Mode

In the description of the embodiments, it will be understood that when a substrate, a layer, a film or an electrode is referred to as being "on" or "under" another substrate, another layer, another film or another electrode, it can be "directly" or "indirectly" on the other substrate, the other layer, the other film, or the other electrode, or one or more intervening layers may also be present. Such a position of the layer has been described with reference to the drawings. The size of the elements shown in the drawings may be exaggerated for the purpose of explanation and may not utterly reflect the actual size.

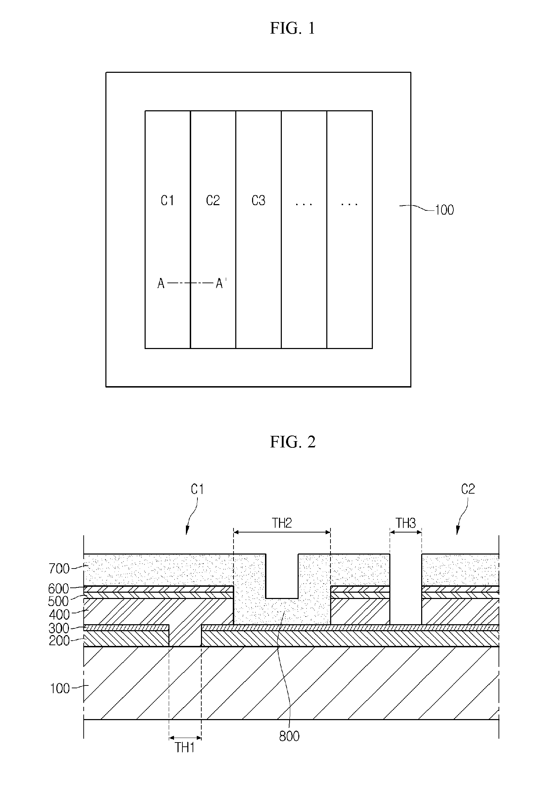

FIG. 1 is a plan view showing a solar cell apparatus according to the embodiment, and FIG. 2 is a sectional view taken along line A-A' of FIG. 1.

Referring to FIGS. 1 and 2, the solar cell apparatus according to the embodiment includes a support substrate 100, a back electrode layer 200, a conductive layer 300, a light absorbing layer 400, a buffer layer 500, a high resistance buffer layer 600, a window layer 700, and a plurality of connection parts 800.

The support substrate 100 has a plate shape and supports the back electrode layer 200, the conductive layer 300, the light absorbing layer 400, the buffer layer 500, the high resistance buffer layer 600, the window layer 700, and the connection parts 800.

The support substrate 100 may include an insulator. The support substrate 100 may include a glass substrate, a plastic substrate, or a metallic substrate. In more detail, the support substrate 100 may include a soda lime glass substrate. The support substrate 100 may be transparent or may be rigid or flexible.

The back electrode layer 200 is provided on the substrate 100. The back electrode layer 200 may be a metallic layer. The back electrode layer 200 may include a metal, such as molybdenum (Mo).

In addition, the back electrode layer 200 may include at least two layers. In this case, the layers may be formed by using the homogeneous metal or heterogeneous metals.

The conductive layer 300 is provided on the back electrode layer 200. The conductive layer 300 covers the whole top surface of the back electrode layer 200. The conductive layer 300 directly makes contact with the back electrode layer 200. In other words, the conductive layer 300 is connected to the back electrode layer 200 by directly making contact with the back electrode layer 200.

In addition, the conductive layer 300 is directly connected to the light absorbing layer 400. In other words, a top surface of the conductive layer 300 directly makes contact with the light absorbing layer 400. Thus, the conductive layer 300 is connected to the light absorbing layer 400.

The conductive layer 300 includes a first conductive oxide. For example, the conductive layer 300 may include a P type oxide. The P type oxide may include a metallic oxide. The P type oxide may include a material selected from the group consisting of indium tin oxide (ITO), tin oxide (TO), or indium tin zinc oxide (ITZO). In detail, the P type oxide may include a metallic oxide doped with a group I element. For example, the P type oxide may include a Na doped ITO, a Na doped TO, or a Na doped IZO.

The conductive layer 300 includes an oxide. In more detail, the conductive layer 300 may consist of an oxide. In other words, the conductive layer 300 is an oxide layer. Accordingly, the conductive layer 300 is stable. In other words, since the oxide is chemically stable more than a metal, the conductive layer 300 is more stable than the back electrode layer 200. Therefore, when the conductive layer 300 is formed, a side reaction between a material constituting the back electrode layer 200 and the P type oxide rarely occurs.

Accordingly, a by-product to degrade the bonding strength between the conductive layer 300 and the back electrode layer 200 is not formed, so that the bonding strength between the conductive layer 300 and the back electrode layer 200 is improved. In addition, the connection characteristic between the conductive layer 300 and the back electrode layer 200 is improved. In other words, the conductive layer 300 is connected to the back electrode layer 200 while representing higher mechanical and electrical connection characteristics.

As described above, the conductive layer 300 may include sodium (Na). The conductive layer 300 may be doped with Na serving as a dopant. In other words, the P type oxide may be doped with Na. The back electrode layer 200 and the light absorbing layer 400 may include Na. In this case, the conductive layer 300 may have the highest Na concentration.

The conductive layer 300 has a thickness of about 1 nm to about 200nm. The conductive layer 300 is transparent and represents low resistance. In addition, the conductive layer 300 may be patterned in the same manner as that of the back electrode layer 200.

The back electrode layer 200 and the conductive layer 300 are formed therein with first through holes TH1. The first through holes TH1 are open regions to expose the top surface of the support substrate 100. When viewed in a plan view, the first through holes TH1 may extend in one direction.

Each first through hole TH1 has a width in the range of about 80µm to about 200µm.

The back electrode layer 200 is divided into a plurality of back electrodes by the first through holes TH1. In other words, the back electrodes are defined by the first through holes TH1.

The back electrodes are spaced apart from each other by the first through holes TH1. The back electrodes are arranged in the form of a stripe.

In addition, the back electrodes may be arranged in the form of a matrix. In this case, the first through holes TH1 may have the form of a lattice when viewed in a plan view.

The light absorbing layer 400 is provided on the back electrode layer 200. In addition, a material constituting the light absorbing layer 400 is filled in the first through holes TH1.

The light absorbing layer 400 includes a first conductive compound semiconductor. For example, the light absorbing layer 400 includes a P type compound semiconductor. In other words, the light absorbing layer 400 is a P type semiconductor layer.

The light absorbing layer 400 includes a group I-III-VI compound. For example, the light absorbing layer 400 may have a Cu(In,Ga)Se₂ (CIGS) crystal structure, a Cu(In)Se₂ crystal structure, or a Cu(Ga)Se₂ crystal structure.

The light absorbing layer 400 has an energy bandgap in the range of about 1eV to about 1.8eV.

The buffer layer 500 is provided on the light absorbing layer 400. The buffer layer 500 includes CdS and has an energy bandgap in the range of about 2.2eV to about 2.4eV.

The high resistance buffer layer 600 is provided on the buffer layer 500. The high-resistance buffer layer 600 may include iZnO, which is zinc oxide not doped with impurities. The high resistance buffer layer 600 has an energy bandgap in the range of about 3.1eV to about 3.3eV.

The light absorbing layer 400, the buffer layer 500, and the high resistance buffer layer 600 are formed therein with second through holes TH2. The second through holes TH2 are formed by perforating the light absorbing layer 400. In addition, the second through holes TH2 are open regions to expose the top surface of the conductive layer 300.

The second through holes TH2 are adjacent to the first through holes TH1. In other words, when viewed in a plan view, portions of the second through holes TH2 are formed beside the first through holes TH1.

Each second through holes TH2 may have a width in the range of about 80*µ*m to about 200*µ*m.

The light absorbing layer 400 defines a plurality of light absorbing parts by the second through holes TH2. In other words, the light absorbing layer 400 is divided into the light absorbing parts by the second through holes TH2.

The window layer 700 is provided on the high resistance buffer layer 600. The window layer 700 is transparent, and includes a conductive layer. In addition, the window layer 700 has resistance greater than that of the back electrode layer 200. For example, the resistance of the window layer 700 may be about 10 times to 200 times greater than the resistance of the back electrode layer 200.

The window layer 700 includes an oxide. In more detail, the window layer 700 includes a second conductive oxide. In other words, the window layer 700 is an N type oxide layer.

In more detail, the window layer 700 may include a metallic oxide doped with a group III element. For example, the window layer 700 may include an Al doped zinc oxide (AZO), or a Ga doped zinc oxide (GZO). The window layer 700 has a thickness in the range of about 800nm to about 1200nm.

The buffer layer 500, the high resistance buffer layer 600, and the window layer 700 are formed therein with third through holes TH3. The third through holes TH3 are open regions to expose the top surface of the conductive layer 300. For example, each third through hole TH3 has a width in the range of about 80*µ*m to about 200µm.

The third through holes TH3 are adjacent to the second through holes TH2. In other words, the third through holes TH3 are provided beside the second through holes TH2. In other words, when viewed in a plan view, the third through holes TH3 are provided in parallel to the second through holes TH2.

The buffer layer 500 is divided into a plurality of buffers by the second through holes TH2 and the third through holes TH3.

Similarly, the high resistance buffer layer 600 is divided into a plurality of high resistance buffers by the second through holes TH2 and the third through holes TH3.

The window layer 700 is divided into a plurality of windows by the third through holes TH3. In other words, the windows are defined by the third through holes TH3.

The windows form a shape corresponding to that of the back electrodes. In other words, the windows are arranged in the form of a stripe. In addition, the windows may be arranged in the form of a matrix.

A plurality of cells C1, C2, ..., and CN are defined by the third through holes TH3. In detail, the cells C1, C2, ..., and CN are defined by the second through hole TH2 and the third through hole TH3. In other words, the solar cell apparatus according to the embodiment is divided into the cells C1, C2,..., and CN by the second and third through holes TH2 and TH3.

The connection parts 800 are provided at the inside of the second through holes TH2. Each connection part 800 extends downward from the window layer 700 and is connected to the conductive layer 300. In more detail, each connection part 800 is connected to the back electrode layer 200 through the conductive layer 300. For example, each connection part 800 extends from a window of the first cell C1 and is connected to a back electrode of the second cell C2 through the conductive layer 300.

In addition, the connection parts 800 connect adjacent cells to each other. In more detail, the connection parts 800 connect windows and back electrodes, which constitute adjacent cells, to each other.

Each connection part 800 is integrally formed with the window layer 700. In other words, a material constituting the connection part 800 is identical to a material constituting the window layer 700.

As described above, the conductive layer 300 can represent high bonding strength with respect to both of the back electrode layer 200 and the light absorbing layer 400. Therefore, the conductive layer 300 enhances the bonding strength between the back electrode layer 200 and the light absorbing layer 400, so that the solar cell apparatus according to the embodiment represents an improved mechanical characteristic.

In addition, as described above, the conductive layer 300 and the back electrode layer 200 are connected to each other while representing a high bonding characteristic therebetween. Since both of the conductive layer 300 and the connection part 800 include a conductive oxide, the connection characteristic between the connection part 800 and the conductive layer 300 is improved. Therefore, the connection characteristic between the connection part 800 and the back electrode layer 200 is improved by the conductive layer 300.

In addition, the conductive layer 300 may include a P type conductive oxide such as a CIGS based compound constituting the light absorbing layer 400. Therefore, the conductive layer 300 is connected to the light absorbing layer 400 while representing an improved connection characteristic. In addition, the conductive layer 300 can improve the connection characteristic between the light absorbing layer 400 and the back electrode layer 200.

Therefore, the solar cell apparatus according to the embodiment has an improved electrical characteristic.

In addition, the back electrode layer 200 can be protected by the conductive layer 300. In more detail, the conductive layer 300 covers a portion of the back electrode layer 200 exposed through the third through holes TH3. Therefore, the conductive layer 300 prevents the back electrode layer 200 from being corroded, so that the solar cell apparatus according to the embodiment represents improved durability.

In addition, the conductive layer 300 may include Na. The Na of the conductive layer 300 is spread into the light absorbing layer 400 in the process of forming the light absorbing layer 400, so that the characteristic of the light absorbing layer 400 can be improved.

Accordingly, the solar cell apparatus according to the embodiment has improved mechanical and electrical characteristics.

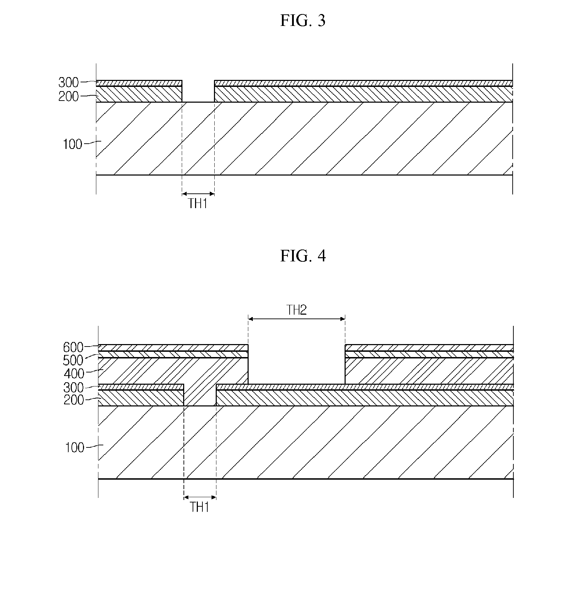

FIGS. 3 to 7 are sectional views showing the fabricating method of the solar cell apparatus according to the embodiment. The present fabricating method will be described by making reference to the above description of the solar cell apparatus. In other words, the above description of the solar cell apparatus may be incorporated with the description of the present fabricating method.

Referring to FIG. 3, the back electrode layer 200 is formed on the support substrate 100. The back electrode layer 200 may be formed through a sputtering process employing a Mo target. The back electrode layer 200 has a thickness in the range of about 100nm to about 500nm.

In addition, an additional layer such as an anti-diffusion layer may be interposed between the support substrate 100 and the back electrode layer 200.

Thereafter, the conductive layer 300 is formed on the back electrode layer 200.

The conductive layer 300 may be formed through the sputtering process. The conductive layer 300 may be formed by using a sputtering target including a P type oxide. In addition, the sputtering target may be doped with Na. In other words, the sputtering target may include a P type oxide doped with Na.

For example, a material constituting the sputtering target may include a Na doped ITO, a Na doped TO, or a Na doped IZO.

The conductive layer 300 may be deposited at a thickness in the range of about 1nm to about 200nm. The conductive layer 300 may be doped with Na. In this case, the concentration of Na doped into the sputtering target may be varied according to the thickness of the conductive layer 300. In other words, when the conductive layer 300 has a thin thickness, Na may be doped at higher concentration. In contrast, when the conductive layer 300 has a thick thickness, Na may be doped at lower concentration.

Thereafter, a plurality of the first through holes TH1 are formed in the back electrode layer 200 and the conductive layer 300 by a laser. In other words, the back electrode layer 200 and the conductive layer 300 are simultaneously patterned. Therefore, the back electrode layer 200 is divided into a plurality of back electrodes by the first through holes TH1.

The first through holes TH1 may expose the top surface of the support substrate 100, and may have a width in the range of about 80µm to about 200µm.

Referring to FIG. 4, the light absorbing layer 400, the buffer layer 500, and the high resistance buffer layer 600 are formed on the conductive layer 300.

The light absorbing layer 400 may be formed through a sputtering process or an evaporation process.

For example, the light absorbing layer 400 may be formed through various schemes such as a scheme of forming a Cu(In,Ga)Se₂ (CIGS) based light absorbing layer 400 by simultaneously or separately evaporating Cu, In, Ga, and Se and a scheme of performing a selenization process after a metallic precursor layer has been formed.

Regarding the details of the selenization process after the formation of the metallic precursor layer, the metallic precursor layer is formed on the back electrode layer 200 through a sputtering process employing a Cu target, an In target, a Ga target or an alloy target.

Thereafter, the metallic precursor layer is subject to the selenization process so that the Cu (In, Ga) Se₂ (CIGS) based light absorbing layer 400 is formed.

In addition, the sputtering process employing the Cu target, the In target, and the Ga target and the selenization process may be simultaneously performed.

Further, a CIS or a CIG based light absorbing layer 400 may be formed through the sputtering process employing only Cu and In targets or only Cu and Ga targets and the selenization process.

Thereafter, the buffer layer 500 is formed by depositing CdS through a sputtering process or a chemical bath deposition (CBD) scheme.

Next, the high resistance buffer layer 600 is formed by depositing a zinc oxide on the buffer layer 500 through the sputtering process.

The buffer layer 500 and the high resistance buffer layer 600 are deposited at a lower thickness. For example, the thickness of the buffer layer 500 and the high resistance buffer layer 600 is in the range of about 1nm to about 80nm.

The second through holes TH2 are formed by removing portions of the light absorbing layer 400, the buffer layer 500, and the high resistance buffer layer 600.

The second through holes TH2 may be formed by a mechanical device such as a tip or a laser device.

For example, the light absorbing layer 400 and the buffer layer 500 may be patterned by the tip having a width in the range of about 40µm to about 180µm. In addition, the second through holes TH2 may be formed by a laser having a wavelength in the range of about 200nm to about 600nm.

In this case, each second through hole TH2 has a width in the range of about 80µm to about 200µm. In addition, the second through holes TH2 expose the top surface of the conductive layer 300.

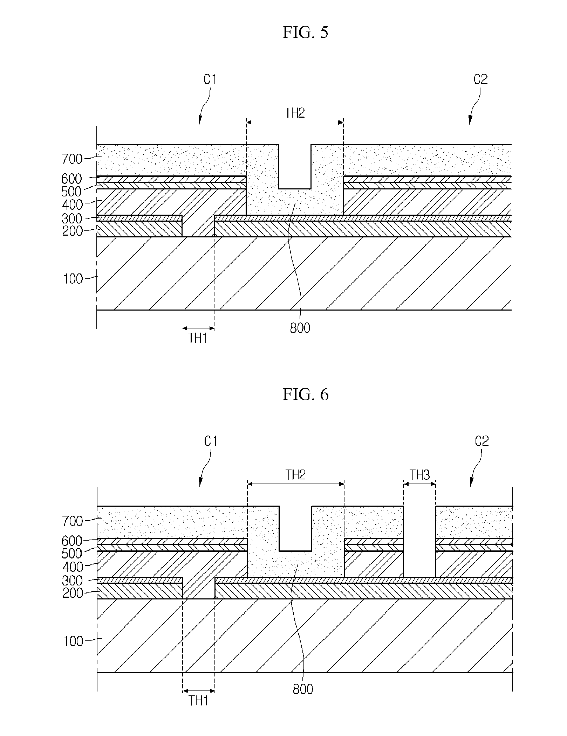

Referring to FIG. 5, the window layer 700 is formed on the light absorbing layer 400 and inside the second through holes TH2. In other words, the window layer 700 is formed by depositing a transparent conductive material on the high resistance buffer layer 600 and inside the second through holes TH2. In more detail, the window layer 700 may be formed by depositing an Al doped zinc oxide.

In this case, the transparent conductive material is filled in the second through holes TH2, so that the window layer 700 directly makes contact with the conductive layer 300. Therefore, the connection parts 800 are formed in the second through holes TH2.

Referring to FIG. 6, the third through holes TH3 are formed by removing portions of the buffer layer 500, the high resistance buffer layer 600, and the window layer 700. Accordingly, the window layer 700 is patterned to define a plurality of windows and a plurality of cells C1, C2, ..., and CN. The width of each third through hole TH3 may be in the range of about 80µm to about 200µm.

The third through holes TH3 expose the top surface of the conductive layer 300. In this case, the conductive layer 300 includes an oxide to effectively protect the back electrode layer 200. In other words, the conductive layer 300 prevents the back electrode layer 200 from being exposed to the outside through the third through holes TH3.

As described above, the solar cell apparatus including the conductive layer 300 is formed. The solar cell apparatus according to the embodiment has improved electrical and mechanical characteristics.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effects such feature, structure, or characteristic in connection with other ones of the embodiments.

Although embodiments have been described with reference to a number of illustrative embodiments thereof, it should be understood that numerous other modifications and embodiments can be devised by those skilled in the art that will fall within the spirit and scope of the principles of this disclosure. More particularly, various variations and modifications are possible in the component parts and/or arrangements of the subject combination arrangement within the scope of the disclosure, the drawings and the appended claims. In addition to variations and modifications in the component parts and/or arrangements, alternative uses will also be apparent to those skilled in the art.

### Industrial Applicability

The solar cell apparatus according to the embodiment and a method of fabricating the same are applicable to the field of solar light generation.

## Claims

1. A solar cell apparatus comprising:
a substrate;
a back electrode layer on the substrate;
a light absorbing layer on the back electrode layer;
a window layer on the light absorbing layer; and
a conductive layer interposed between the back electrode layer and the light absorbing layer and including a first conductive oxide.

2. The solar cell apparatus of claim 1, wherein the first conductive oxide includes a P type oxide.

3. The solar cell apparatus of claim 1, wherein the conductive layer includes sodium (Na).

4. The solar cell apparatus of claim 1, wherein the conductive layer includes a material selected from the group consisting of indium tin oxide (ITO), tin oxide (TO), and indium tin zinc oxide (ITZO).

5. The solar cell apparatus of claim 1, wherein the light absorbing layer is formed therein with a through hole to expose the conductive layer, and a connection part is provided in the through hole while extending from the window layer, so that the connection part is connected to the conductive layer.

6. The solar cell apparatus of claim 5, wherein the connection part is connected to the back electrode layer through the conductive layer.

7. The solar cell apparatus of claim 1, wherein the conductive layer has a thickness in a range of about 1nm to about 200nm.

8. The solar cell apparatus of claim 1, wherein the light absorbing layer includes a material having a conductive type a same as a conductive type of the first conductive oxide, and the window layer includes a second conductive material.

9. A solar cell apparatus comprising:
a back electrode layer;
a first conductive oxide layer on the back electrode layer;
a first conductive light absorbing layer on the first conductive oxide layer; and
a second conductive window layer on the first conductive light absorbing layer.

10. The solar cell apparatus of claim 9, wherein the first conductive oxide layer includes a metallic oxide doped with a group I element.

11. The solar cell apparatus of claim 10, wherein the first conductive light absorbing layer includes a group I-III-VI based compound semiconductor, and the window layer includes a metallic oxide doped with a group III element.

12. The solar cell apparatus of claim 10, wherein the group I element includes sodium (Na).

13. The solar cell apparatus of claim 9, wherein the first conductive oxide layer has a thickness in a range of about 1nm to about 200nm.

14. The solar cell apparatus of claim 9, further comprising a third through hole formed by perforating the window layer and the light absorbing layer, wherein the third through hole exposes a top surface of the first conductive oxide layer.

15. A method of fabricating a solar cell apparatus, the method comprising:
forming a back electrode layer on a substrate;
forming a conductive layer by depositing a first conductive oxide on the back electrode layer;
forming a light absorbing layer on the conductive layer; and
forming a window layer on the light absorbing layer.

16. The method of claim 15, wherein the first conductive oxide includes a material selected from the group consisting of indium tin oxide (ITO), tin oxide (TO), and indium tin zinc oxide (ITZO), and the light absorbing layer includes a group I-III-IV compound.

17. The method of claim 16, further comprising:
forming a through hole in the light absorbing layer to expose a top surface of the conductive layer; and
depositing a transparent conductive material in the through hole when forming the window layer.
